# EUROPEAN PATENT APPLICATION

(11) **EP 4 803 217 A2**
(43) Date of publication of application: **09.09.2026**
(21) Application number: 25221422.6
(22) Date of filing: 08.12.2025
(51) Int. Cl.: B09B 3/35, B03B 9/06, B09B 101/15

(54) **WASTE SOLAR PANEL CRUSHING AND SEPARATION/RECOVERY APPARATUS AND METHOD FOR CRUSHING AND SEPARATING/RECOVERING WASTE SOLAR PANELS**

(30) Priority: 18.12.2024 KR 20240190068
(71) Applicant: Won Kwang S&T Co., Ltd., Incheon 22845 (KR)
(72) Inventor: SANG HUN, LEE, Incheon, 21683 (KR); KIM, JUN KEE, Seoul, 08008 (KR); NOH, CHEONG MIN, Incheon, 22801 (KR); IM, BYEOL I, Incheon, 22776 (KR); SEO, KWANG MIN, Incheon, 22758 (KR); LEE, DO YUN, Incheon, 22732 (KR)
(74) Representative: dompatent

(57) **Abstract**

Disclosed are an apparatus and method for crushing and separating waste solar panels to recover recyclable components. A first crushing unit breaks a waste solar panel into crushed material, and a second crushing unit re-grinds the crushed material into ground particles. A particle-size classifying unit separates the ground particles into first particles having a particle size smaller than a reference particle size and intermediate particles having a particle size larger than the reference particle size. A gravity separation unit further divides the intermediate particles into second and third particles according to specific gravity. First to third recovery units respectively suction and discharge ground particles from the second crushing unit, first particles from the particle-size classifying unit, and second particles from the gravity separation unit through nozzles.

## Description

### BACKGROUND OF THE INVENTION

### FIELD OF THE INVENTION

The present invention relates to a technology for treating waste solar panels, and more particularly, to a waste solar panel crushing and separation/recovery apparatus and to a method for crushing and separating/recovering waste solar panels, in which components contained in waste solar panels are selectively separated and recovered so as to be recyclable.

### DESCRIPTION OF RELATED ART

Solar panels (solar modules) applied to a solar power system are separated from the system and discarded when their service life expires. However, since a solar panel is a composite structure including tempered glass, a semiconductor material (such as silicon), a metal (such as copper used as an electrode or transmission line), plastics, and the like, a process of separating reusable components is required instead of simple disposal.

For example, a process (for example, a delamination process) for recovering a glass component by separating tempered glass from a waste solar panel is known. Since the tempered glass is attached to the front surface of the solar panel in the form of a glass plate, it can be appropriately separated by cutting the solar panel with a blade or the like (for example, Korean Registered Patent No. 10-2351390).

However, the remaining components are embedded in thin layered structures such as a cell layer and a backsheet layer on the opposite side of the glass plate, and thus it is very difficult to separate them by component. As a result, particularly useful components (such as silicon and copper) are simply discarded or cannot be recovered, which is disadvantageous in terms of resource recycling. Therefore, a more effective alternative has been required from the standpoint of resource recycling.

The present invention was carried out as part of a National R&D Project supported by the Ministry of Trade, Industry and Energy (MOTIE) and managed by the Korea Energy Technology Evaluation and Planning (KETEP). The research project name is 'Renewable Energy Key Technology Development (R&D),' and the specific task name is 'Development of Module Material and Process Technology with Low Carbon Emission and Easy Recycling.' The unique project number is 1415188791, and the project number is RS-2023-00303745. The performing organization for this task is Wonkwang S&T Co., Ltd., and the research period is from November 1, 2023, to October 31, 2026.

### SUMMARY OF THE INVENTION

The technical problem of the present invention is to provide a waste solar panel crushing and separation/recovery apparatus which selectively separates and recovers components contained in waste solar panels so that they are recyclable, and to provide, in addition, a method for crushing and separating/recovering waste solar panels which selectively separates and recovers components contained in waste solar panels so that they are recyclable.

The technical problems of the present invention are not limited to the above-described problems, and other technical problems not mentioned will be clearly understood by those skilled in the art from the following description.

According to one aspect of the present invention, there is provided a waste solar panel crushing and separation/recovery apparatus comprising:
a first crushing unit configured to crush a waste solar panel into crushed material having a size allowing the crushed material to be transported through a flow path;
a second crushing unit configured to re-grind the crushed material so as to convert the crushed material into ground particles having a particle size smaller than that of the crushed material;
a particle separation unit comprising a particle-size classifying unit configured to separate the ground particles into first particles having a particle size smaller than a reference particle size and intermediate particles having a particle size larger than the reference particle size, and a gravity separation unit connected to the particle-size classifying unit and configured to re-separate the intermediate particles into second particles lighter in specific gravity and third particles heavier in specific gravity;
a first recovery unit configured to suction the ground particles from the second crushing unit by air pressure and discharge the ground particles through a nozzle;
a second recovery unit configured to suction the first particles from the particle-size classifying unit by air pressure and discharge the first particles through a nozzle; and
a third recovery unit configured to suction the second particles from the gravity separation unit by air pressure and discharge the second particles through a nozzle.

The apparatus may further include a particle collection unit configured to suction the second particles from the gravity separation unit along a path different from the third recovery unit and mix the second particles with the first particles, and a fourth recovery unit configured to suction mixed particles of the first particles and the second particles from the particle collection unit and discharge the mixed particles through a nozzle.

The apparatus may further include a branching flow path disposed between the gravity separation unit and the particle collection unit and between the gravity separation unit and the third recovery unit, and configured to selectively change a flow path of the second particles to the particle collection unit or to the third recovery unit.

Each of the first recovery unit, the second recovery unit, the third recovery unit, and the fourth recovery unit may comprise a cyclone barrel having a diameter decreasing downward, a nozzle formed at a lower end of the cyclone barrel, a suction conduit connected in a tangential direction to a side portion of the cyclone barrel, and a suction fan coupled to an upper end of the cyclone barrel and configured to generate a negative pressure.

Each of the first recovery unit, the second recovery unit, the third recovery unit, and the fourth recovery unit may further comprise a dust discharge duct connected to the suction fan so that dust centrifugally separated is discharged to a dust collector through the dust discharge duct.

The suction conduit and the dust discharge duct may be doubly connected in tangential directions to a side portion and an upper end of the cyclone barrel.

The apparatus may further include a first suction unit disposed at an upper end of the second crushing unit and connected by a flow path to the first crushing unit so as to suction the crushed material into the second crushing unit, and a second suction unit disposed at an upper end of the particle-size classifying unit and connected by a flow path to the second crushing unit so as to suction the ground particles into the particle-size classifying unit. Each of the first suction unit and the second suction unit may comprise an auxiliary cyclone barrel having a diameter decreasing downward, an auxiliary suction conduit connected in a tangential direction to a side portion of the auxiliary cyclone barrel, and an auxiliary suction fan coupled to an upper end of the auxiliary cyclone barrel and configured to generate a negative pressure.

The particle-size classifying unit may comprise a vibrating particle classifier including a sieve, and the gravity separation unit may comprise an airflow gravity separator.

The first particles may be silicon, and the third particles may be copper.

According to another aspect of the present invention, there is provided a waste solar panel crushing and separation/recovery apparatus comprising:
a first crushing unit configured to crush a waste solar panel into crushed material having a size allowing the crushed material to be transported through a flow path;
a second crushing unit configured to re-grind the crushed material so as to convert the crushed material into ground particles having a particle size smaller than that of the crushed material;
a particle separation unit comprising a particle-size classifying unit configured to separate the ground particles into first particles having a particle size smaller than a reference particle size and intermediate particles having a particle size larger than the reference particle size, and a gravity separation unit interlocked with the particle-size classifying unit and configured to re-separate the intermediate particles into second particles lighter in specific gravity and third particles heavier in specific gravity;
a recovery unit configured to suction, by air pressure, any one of the ground particles, the first particles, and the second particles from any one of the second crushing unit, the particle-size classifying unit, and the gravity separation unit and discharge the suctioned particles through a nozzle; and
a dust collector connected to the recovery unit,
whereby, when any one of the ground particles, the first particles, and the second particles is recovered through the recovery unit, dust can be removed from recovered material.

The recovery unit may comprise a cyclone barrel having a diameter decreasing downward, a nozzle formed at a lower end of the cyclone barrel, a suction conduit connected in a tangential direction to a side portion of the cyclone barrel, a suction fan coupled to an upper end of the cyclone barrel and configured to generate a negative pressure, and a dust discharge duct connected to the suction fan, such that dust centrifugally separated inside the cyclone barrel is discharged to the dust collector through the dust discharge duct, and any one of the ground particles, the first particles, and the second particles is discharged through the nozzle.

A load of the suction fan and a load of the dust collector may be simultaneously adjusted so as to adjust a suction force of the recovery unit.

The suction conduit and the dust discharge duct may be doubly connected in tangential directions to a side portion and an upper end of the cyclone barrel.

According to still another aspect of the present invention, there is provided a method for crushing and separating/recovering waste solar panels, the method comprising:
(a) crushing a waste solar panel into crushed material having a size allowing the crushed material to be transported through a flow path;
(b) re-grinding the crushed material so as to convert the crushed material into ground particles having a particle size smaller than that of the crushed material;
(c) in a particle-size classifying unit, separating the ground particles into first particles having a particle size smaller than a reference particle size and intermediate particles having a particle size larger than the reference particle size;
(d) in a gravity separation unit, re-separating the intermediate particles into second particles having a smaller specific gravity and third particles having a larger specific gravity according to a difference in specific gravity; and
(e) separating and recovering the first particles and the third particles respectively from the particle-size classifying unit and the gravity separation unit.

In step (e), the second particles may be recovered along a first path independent of recovery paths of the first particles and the third particles, or may be recovered along a second path identical to a recovery path of the first particles.

When the second particles are recovered along the second path, the second particles may be recovered in a state of mixed particles mixed with the first particles through a particle collection unit configured to suction the second particles from the gravity separation unit and mix the second particles with the first particles.

The particle-size classifying unit may comprise a vibrating particle classifier including a sieve, and the gravity separation unit may comprise an airflow gravity separator.

The first particles may be silicon, and the third particles may be copper.

According to the present invention, when waste solar panels are disposed of, useful components (such as silicon and copper) contained in the waste solar panels can be selectively separated and recovered by item. Therefore, no additional process is required to separate each component, and the recovered components can be supplied directly to a required destination for recycling immediately after disposal. In addition, it is possible, as needed, to combine or separate two or more components and to select recovery points, so that necessary components can be recovered and reused extremely efficiently from waste solar panels. Furthermore, foreign substances (dust) mixed in recovered material are automatically separated and discharged in all recovery processes, thereby improving the purity of the recovered material.

### BRIEF DESCRIPTION OF THE DRAWINGS

FIG. 1 is a perspective view of a waste solar panel crushing and separation/recovery apparatus according to an embodiment of the present invention.
FIG. 2 is a perspective view of the waste solar panel crushing and separation/recovery apparatus of FIG. 1 with a frame removed.
FIG. 3 is an exploded view of a main portion of the crushing and separation/recovery apparatus of FIG. 2.
FIG. 4 is a view illustrating the crushing and separation/recovery apparatus of FIG. 3 from another angle.
FIG. 5 is an enlarged perspective view of a particle separation unit portion of the crushing and separation/recovery apparatus of FIG. 4.
FIG. 6 is a view illustrating the particle separation unit portion of FIG. 5 from another angle.
FIG. 7 is a front view of the crushing and separation/recovery apparatus of FIG. 3.
FIG. 8 is a sectional view illustrating an internal structure of a recovery unit included in the crushing and separation/recovery apparatus of FIG. 7.
FIG. 9 is a rear view of the crushing and separation/recovery apparatus of FIG. 3.
FIG. 10 is a plan view of the crushing and separation/recovery apparatus of FIG. 3.
FIG. 11 is a perspective view of the crushing and separation/recovery apparatus of FIG. 3 as viewed from a bottom side.
FIGS. 12A and 12B are operational views illustrating a first recovery process of the crushing and separation/recovery apparatus of FIG. 2 from different angles.
FIGS. 13A and 13B are operational views illustrating a second recovery process of the crushing and separation/recovery apparatus of FIG. 2 from different angles.
FIGS. 14A and 14B are operational views illustrating a third recovery process of the crushing and separation/recovery apparatus of FIG. 2 from different angles.
FIGS. 15 to 17 are process diagrams schematically illustrating first to third recovery processes shown in FIGS. 12A to 14B.

### DETAILED DESCRIPTION OF THE INVENTION

The advantages and features of the present invention and methods for achieving them will be clearly understood from the embodiments described in detail below with reference to the accompanying drawings. However, the present invention is not limited to the embodiments disclosed below, and may be embodied in various different forms. Rather, the embodiments are provided so that this disclosure is complete and so that those skilled in the art to which the present invention pertains can fully understand the scope of the invention, and the present invention is defined only by the claims. Throughout the specification, like reference numerals refer to like elements.

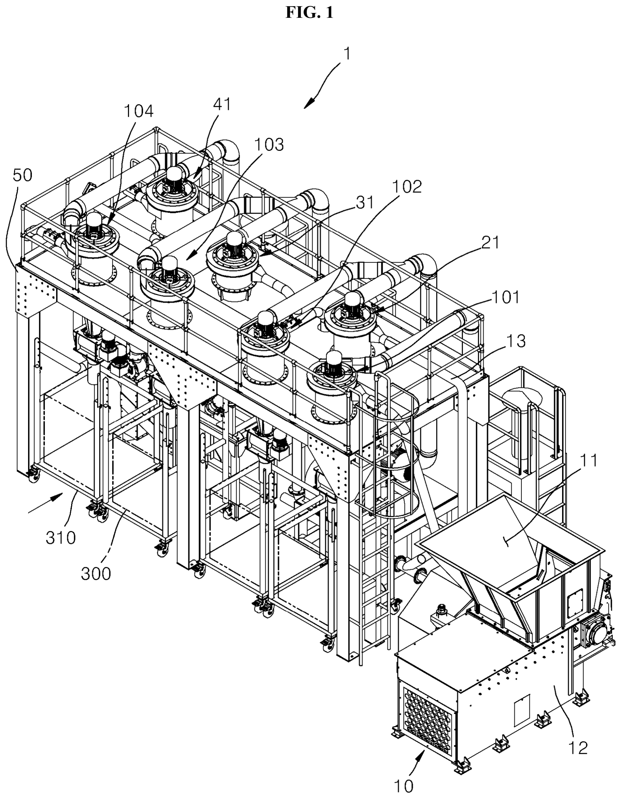

Hereinafter, a waste solar panel crushing and separation/recovery apparatus and a method for crushing and separating/recovering waste solar panels according to the present invention will be described in detail with reference to FIGS. 1 to 17. Since the method of the present invention can be carried out by the apparatus of the present invention, a crushing and separation/recovery apparatus will first be described in detail, and the method will then be described on the basis thereof. The method of the present invention may also be understood in accordance with an operation process of the apparatus.

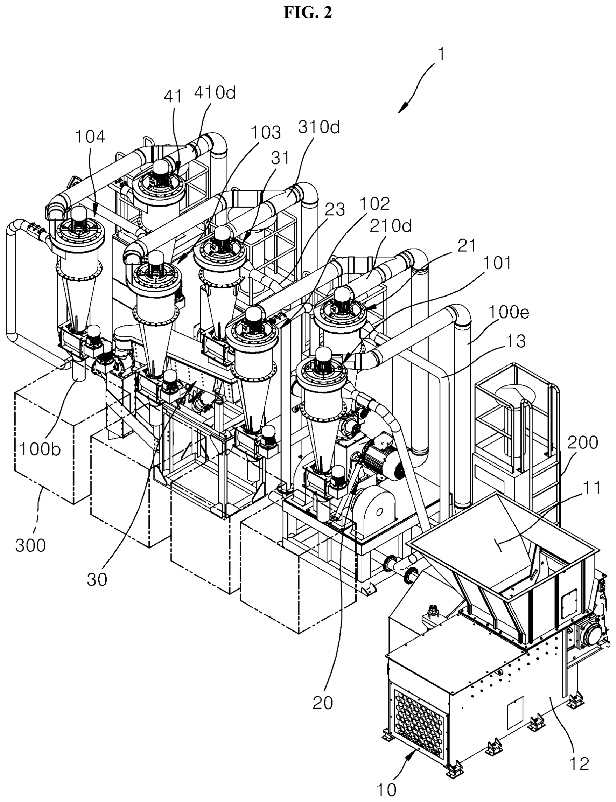

FIG. 1 is a perspective view of a waste solar panel crushing and separation/recovery apparatus according to an embodiment of the present invention, and FIG. 2 is a perspective view of the waste solar panel crushing and separation/recovery apparatus of FIG. 1 with a frame removed.

Referring to FIG. 1, a waste solar panel crushing and separation/recovery apparatus 1 (hereinafter, simply referred to as a "crushing and separation/recovery apparatus") according to the present invention includes a first crushing unit 10, a second crushing unit 20 (see FIG. 2), a particle separation unit 30 (see FIG. 2), and a plurality of recovery units [first to fourth recovery units 101 to 104] formed at different positions. The recovery units are connected to the second crushing unit 20 and the particle separation unit 30 by flow paths (such as recovery conduits and branching flow paths, which will be described later), and are configured to suction and discharge crushed material of a waste solar panel (ground particles, first particles, second particles, third particles, and the like, which will be described later).

In particular, as illustrated in FIG. 1, the crushing and separation/recovery apparatus 1 may selectively suction crushed material of the waste solar panel through the first recovery unit 101, the second recovery unit 102, the third recovery unit 103, and the fourth recovery unit 104 located at different positions and collect the crushed material in collection boxes 300. Accordingly, different components can be recovered in respective collection boxes 300 and then recycled for desired uses. The collection boxes 300 can be easily transported by using carts 310 or the like.

Referring to FIG. 2, in the present invention, since the crushed material of the waste solar panel is transported by being suctioned through flow paths, a complicated process can be carried out in a limited space. The flow paths are highly organically connected in order to integrate complicated processes. Crushing of the waste solar panel, grinding, separation according to particle-size difference, separation according to specific gravity difference, and selective discharge are all organically coupled by the flow paths. Therefore, it is possible to convert processes by adjusting the flow paths, to combine processes by arranging the flow paths, and thereby to save and optimize space. As a result, a working space that conventionally had to be elongated by use of a conveyor or the like can be reduced, and the apparatus can be efficiently configured in such a manner as to utilize both an upper space and a lower space that are connectable by flow paths.

Through this configuration, the present invention can repeatedly separate the crushed material according to particle size, specific gravity, and the like, and thereby recover, by component (for example, silicon, copper, and the like), materials contained in the waste solar panel. In addition, by adjusting the flow paths and changing suction paths, separated components may be combined or reclassified so that the amount and types of recovered material can be adjusted. Accordingly, recyclable components can be very efficiently selected and recovered simultaneously with disposal of the waste solar panel.

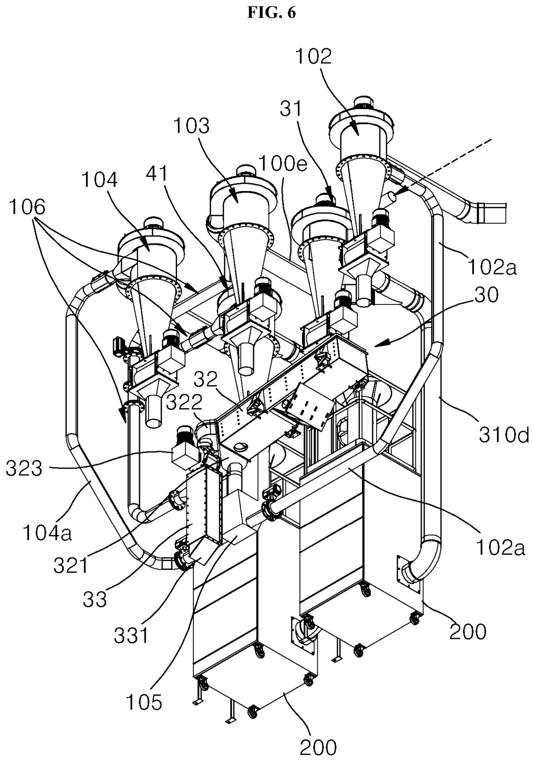

The crushing and separation/recovery apparatus 1 of the present invention is configured as follows. The crushing and separation/recovery apparatus 1 includes: the first crushing unit 10 configured to crush a waste solar panel into crushed material having a size allowing the crushed material to be transported through a flow path; the second crushing unit 20 configured to re-grind the crushed material so as to convert the crushed material into ground particles having a particle size smaller than that of the crushed material; the particle separation unit 30 including a particle-size classifying unit 32 (see FIG. 6) configured to separate the ground particles into first particles having a particle size smaller than a reference particle size and intermediate particles having a particle size larger than the reference particle size, and a gravity separation unit 33 (see FIG. 6) connected to the particle-size classifying unit 32 and configured to re-separate the intermediate particles into second particles lighter in specific gravity and third particles heavier in specific gravity; the first recovery unit 101 configured to suction the ground particles from the second crushing unit 20 by air pressure and discharge the ground particles through a nozzle; the second recovery unit 102 configured to suction the first particles from the particle-size classifying unit 32 by air pressure and discharge the first particles through a nozzle; and the third recovery unit 103 configured to suction the second particles from the gravity separation unit 33 by air pressure and discharge the second particles through a nozzle.

In this case, the first particles may be silicon (including metallurgical-grade silicon) contained in the waste solar panel, and the third particles may be copper. The second particles may be a mixture of the remaining components, and, as needed, may be recovered along a path independent of both the first particles and the third particles, or may be recovered in a state mixed with the first particles. To this end, the crushing and separation/recovery apparatus 1 of this embodiment may further include the following configuration.

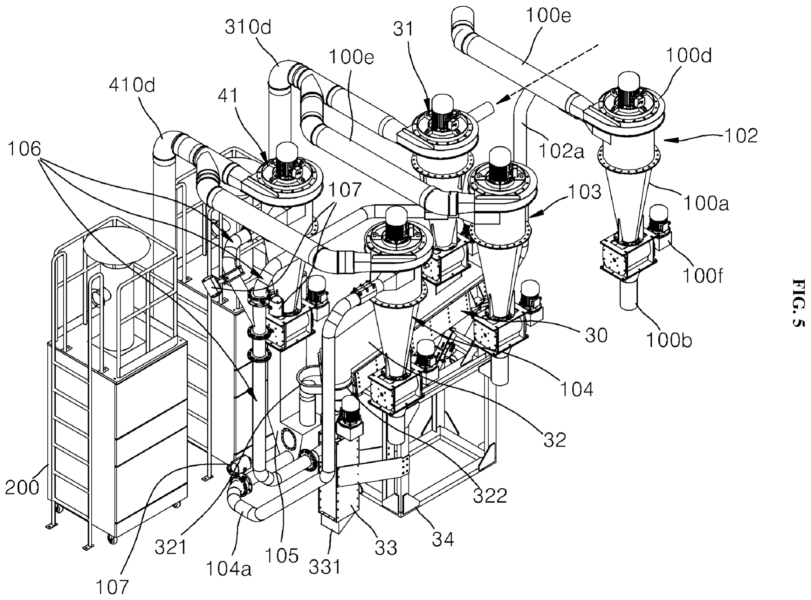

That is, the crushing and separation/recovery apparatus 1 may further include a particle collection unit 105 (see FIG. 5) configured to suction the second particles from the gravity separation unit 33 along a path different from the third recovery unit 103 and mix the second particles with the first particles, and a fourth recovery unit 104 configured to suction mixed particles of the first particles and the second particles from the particle collection unit 105 and discharge the mixed particles through a nozzle. In addition, the apparatus may further include a branching flow path 106 (see FIG. 5) disposed between the gravity separation unit 33 and the particle collection unit 105 and between the gravity separation unit 33 and the third recovery unit 103, and configured to selectively change a flow path of the second particles to the particle collection unit 105 or to the third recovery unit 103. With this configuration, it is also possible to change the types and discharge positions of recovered material. Hereinafter, on the basis of such an embodiment of the present invention, the configuration and operational effects of the present invention will be described in more detail.

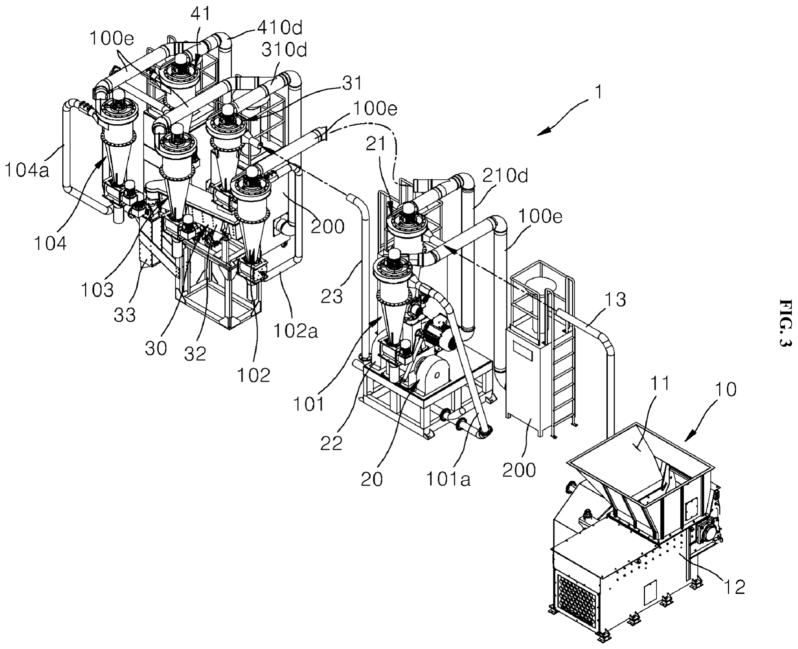

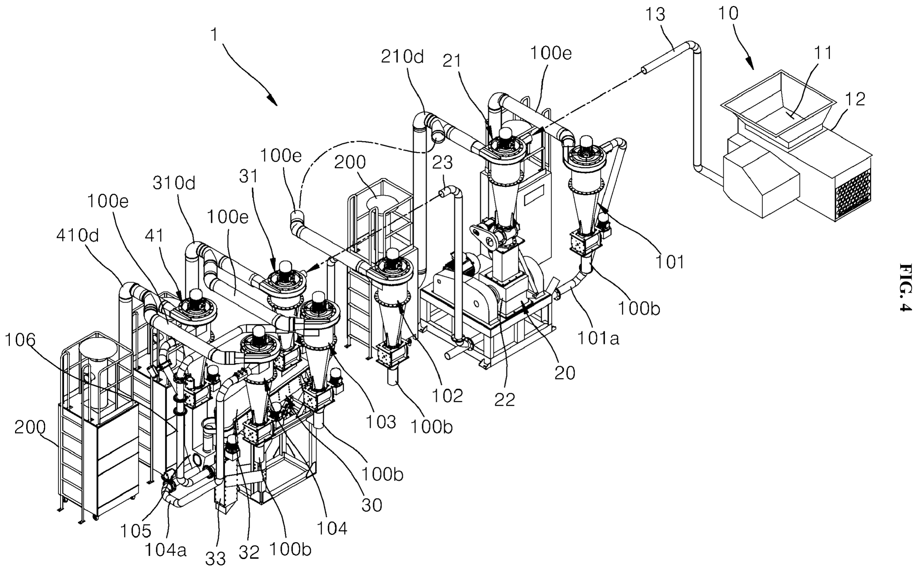

FIG. 3 is an exploded view of a main portion of the crushing and separation/recovery apparatus of FIG. 2, FIG. 4 is a view illustrating the crushing and separation/recovery apparatus of FIG. 3 from another angle, FIG. 5 is an enlarged perspective view of a particle separation unit portion of the crushing and separation/recovery apparatus of FIG. 4, and FIG. 6 is a view illustrating the particle separation unit portion of FIG. 5 from another angle.

In order to show a three-dimensional connection structure of the apparatus connected by flow paths, views in which the same configuration is illustrated from different angles and exploded views in which main portions are separated are referred to in the following description. Referring to FIGS. 3 and 4, a waste solar panel is first crushed in the first crushing unit 10. The first crushing unit 10 may include an inlet 11 into which a waste solar panel (not shown) is introduced, a crushing module 12 connected to the inlet 11, and a first transport conduit 13 extending from the crushing module 12. The first crushing unit 10 crushes the waste solar panel introduced through the inlet 11 into crushed material having a size allowing the crushed material to be transported through a flow path. The crushed material may be in the form of particles and may have a size that can be transported through the first transport conduit 13.

The crushing module 12 may include, for example, one or more crushers. The crushers are not particularly limited so long as they can apply pressure to the waste solar panel to physically break the panel and crush it into smaller pieces. The crushers may include, for example, crushing drums that rotate while meshing with each other. The crushing module 12 may be formed as a housing connected to the inlet 11 and having the crushers mounted therein.

The first transport conduit 13 is a flow path connecting the first crushing unit 10 and the second crushing unit 20, and may have a diameter allowing the crushed material to pass therethrough. The diameter, length, and the like of the first transport conduit 13 may be appropriately adjusted so that air pressure suitable for suctioning the crushed material is generated. The waste solar panel introduced into the first crushing unit 10 may be a panel from which tempered glass has been previously removed by a delamination process or the like, but is not limited thereto and may also be a panel from which such tempered glass has not been removed.

The second crushing unit 20 re-grinds the crushed material of the waste solar panel transferred from the first crushing unit 10 so as to convert the crushed material into ground particles having a particle size smaller than that of the crushed material. The second crushing unit 20 may include a grinding module 22 capable of performing such a grinding operation. The grinding module 22 may include a grinder configured to apply pressure to the crushed material and further grind the crushed material more finely, and the grinder is not particularly limited so long as it can perform such an operation. The grinder may include, for example, a grinding blade rotating at high speed, and may be configured to perform multi-stage grinding so as to sufficiently reduce the size of the ground particles.

Referring to FIG. 4, the second crushing unit 20 is connected at a lower end of the grinding module 22 to a second transport conduit 23 that discharges the ground particles. The second transport conduit 23 is a flow path connecting the second crushing unit 20 to the particle separation unit 30, and its size and diameter may be appropriately adjusted. The diameter, length, and the like of the second transport conduit 23 may likewise be adjusted as needed so that air pressure suitable for suctioning the ground particles is generated. The second transport conduit 23 may be formed so as to branch, at the lower end of the second crushing unit 20, in a direction different from a first recovery conduit 101a connected to the first recovery unit 101.

The second crushing unit 20 may include, at an upper end thereof, a first suction unit 21 configured to suction the crushed material generated in the first crushing unit 10 into the second crushing unit 20. The first suction unit 21 is disposed at the upper end of the second crushing unit 20 and is connected by a flow path (the first transport conduit) to the first crushing unit 10. The first transport conduit 13 is a flow path connecting the first crushing unit 10 and the first suction unit 21 and may, as illustrated, extend vertically from a lower end of the first crushing unit 10 and then be bent to be connected to the first suction unit 21.

The first suction unit 21 may have a function of generating suction force by a fan and a function of separating dust by a cyclone action. Thus, the crushed material can have dust removed in advance in the first suction unit 21 before being introduced into the second crushing unit 20. Suction units including a second suction unit 31 and a third suction unit 41, which will be described later, and recovery units including the first recovery unit 101, the second recovery unit 102, the third recovery unit 103, and the fourth recovery unit 104 also have a dust removal function by a cyclone action. Therefore, in the present invention, dust can be repeatedly removed during intermediate stages of the process so that the purity of recovered material can be increased. The detailed structures of the recovery units and the suction units will be described later.

The first suction unit 21 may be integrally coupled to the upper end of the second crushing unit 20. Since the interior of the first suction unit 21 is in communication with the interior of the second crushing unit 20, negative pressure can be generated by the fan to suction the crushed material, which can then be directly supplied to the second crushing unit 20 at the lower side.

The ground particles re-ground after being introduced into the second crushing unit 20 are supplied to the particle separation unit 30 along the second transport conduit 23 at the lower end of the second crushing unit 20. The particle separation unit 30 performs at least two different separation processes in sequence so that the crushed material of the waste solar panel is separated into particles having different components. The particle separation unit 30 may include, at an upper end thereof, the second suction unit 31 which suctions the ground particles through the second transport conduit 23, and may suction the ground particles by air pressure through the second suction unit 31 and then perform separation processes.

The particle separation unit will be described in more detail with reference to the enlarged views of FIGS. 5 and 6. Referring to FIGS. 5 and 6, the particle separation unit 30 is formed such that the particle-size classifying unit 32 and the gravity separation unit 33 are interlocked with each other so as to continuously separate the ground particles by particle-size difference and specific gravity difference. The particle-size classifying unit 32 separates the ground particles suctioned through the second suction unit 31 into first particles having a particle size smaller than the reference particle size and intermediate particles having a particle size larger than the reference particle size, and the gravity separation unit 33 is connected again to the particle-size classifying unit 32 and separates the intermediate particles into second particles lighter in specific gravity and third particles heavier in specific gravity according to a difference in specific gravity. Through such continuous separation by particle-size difference and specific gravity difference, the ground particles can be separated into the first particles, the second particles, and the third particles, respectively.

As described above, the first particles may be silicon (including metallurgical-grade silicon) contained in the waste solar panel, and the third particles may be copper. The second particles may be a mixture of the remaining components and, depending on user selection, may be recovered along a path independent of the first particles and the third particles, or may be recovered in a state mixed with the first particles. That is, after the waste solar panel is crushed and ground to form the ground particles, continuous separation by particle-size difference and specific gravity difference is performed again so that silicon and copper components contained in the waste solar panel can be selectively recovered in the form of particles.

Referring to FIG. 6, the particle-size classifying unit 32 may be formed as a vibrating particle classifier including a sieve (not shown). The particle-size classifying unit 32 may be formed as a housing or the like having one or more sieves installed therein and inclined. The particle-size classifying unit 32 receives the ground particles from the second crushing unit 20 through the second suction unit 31 connected to the upper end thereof, and discharges the ground particles as the first particles and the intermediate particles by separation according to particle-size difference. Various types of vibration devices (for example, vibrators coupled with motors) for inducing vibration to accelerate separation may be installed in the particle-size classifying unit 32.

At an end of the particle-size classifying unit 32, a first outlet 321 for discharging the first particles and a second outlet 322 for discharging the intermediate particles may be formed. The first outlet 321 is connected to the second recovery unit 102 via the particle collection unit 105, and the second outlet 322 may be directly connected to the gravity separation unit 33. The first outlet 321 may be formed so as to discharge particles having a particle size smaller than the reference particle size that have passed through the sieve at a relatively lower position, and the second outlet 322 may be formed so as to discharge particles having a larger particle size that have remained on the sieve at a relatively higher position. By adjusting the specification (mesh size) of the sieve disposed inside, it is also possible to adjust the size of the reference particle size that distinguishes the first particles from the intermediate particles. The number of sieves may be one or two or more, and, if necessary, sieves having different meshes may be used in an overlapped manner.

The second suction unit 31 is disposed to suction the ground particles ground in the second crushing unit 20 into the particle-size classifying unit 32. The second suction unit 31 is disposed at an upper end of the particle-size classifying unit 32 and is connected by a flow path (the second transport conduit) to the second crushing unit 20. The second transport conduit 23 (see FIG. 4) is a flow path connecting the second crushing unit 20 and the second suction unit 31 and may extend vertically from the lower end of the second crushing unit 20 and then be bent to be connected to the second suction unit 31.

As described above, the second suction unit 31 also has a function of generating suction force by driving a fan, and a function of separating dust by a cyclone action. Therefore, dust can be removed in advance from the ground particles in the second suction unit 31 before the ground particles are introduced into the particle-size classifying unit 32.

The gravity separation unit 33 may be formed as, for example, an airflow gravity separator. As illustrated in FIGS. 5 and 6, the gravity separation unit 33 is directly connected to the second outlet 322 of the particle-size classifying unit 32 and may extend downward. The gravity separation unit 33 may be formed, for example, as a housing having an empty interior, and may further include an air injection device (not shown) configured to inject air in an appropriate direction so as to provide wind pressure to the intermediate particles falling into the interior and separate the intermediate particles into the third particles and the second particles according to a difference in specific gravity. The gravity separation unit 33 can separate the relatively light second particles and the heavier third particles by using wind power in this manner, and its structure is not limited so long as it can perform such a function, and thus its shape can be variously modified. A partition plate or the like for temporarily receiving particles separated by wind power may also be applied inside the gravity separation unit 33. A shutoff member 323 capable of opening and closing a flow path may also be applied between the gravity separation unit 33 and the particle-size classifying unit 32.

The gravity separation unit 33 may include, at a lower end thereof, a third outlet 331 for discharging the relatively heavy third particles (copper). At an upper end of the gravity separation unit 33, the branching flow path 106 may be connected so as to suction the lighter second particles and supply the second particles to different discharge paths (the third recovery unit or the particle collection unit). Referring to FIG. 5, the branching flow path 106 may be formed as a branched conduit having at least one branching point, and may be disposed between the gravity separation unit 33 and the particle collection unit 105 and between the gravity separation unit 33 and the third recovery unit 103 so as to selectively change the flow path of the second particles separated in the gravity separation unit 33 to the particle collection unit 105 or to the third recovery unit 103. The branching flow path 106 may be connected to the particle collection unit 105 via the third suction unit 41, and may be directly connectable to the third recovery unit 103. The structure and operation of the particle collection unit 105 and the branching flow path 106 will be described in detail later.

As described above, in the present invention, the crushed material (a product generated in the first crushing unit) and the ground particles (a product generated in the second crushing unit) are sequentially generated in the first crushing unit 10 (see FIG. 4) and the second crushing unit 20 (see FIG. 4), and are then separated into the first to third particles (three types of separated material generated by continuous separation by particle-size difference and specific gravity difference) in the particle separation unit 30. Since the ground particles, the first particles, the second particles, and the third particles have different discharge positions, recovered material formed by crushing the waste solar panel can be selectively recovered at different points by using different recovery units applied to respective particles. Hereinafter, the configuration and operational effects of the recovery units will be described in more detail.

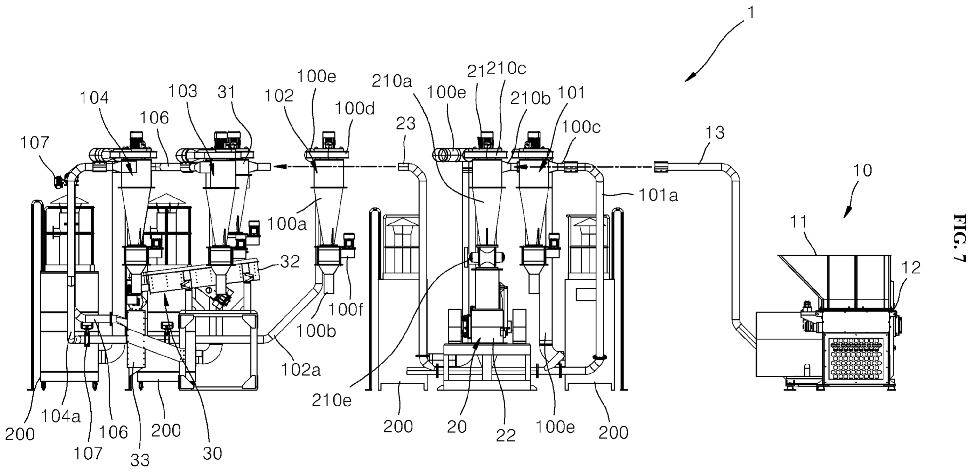

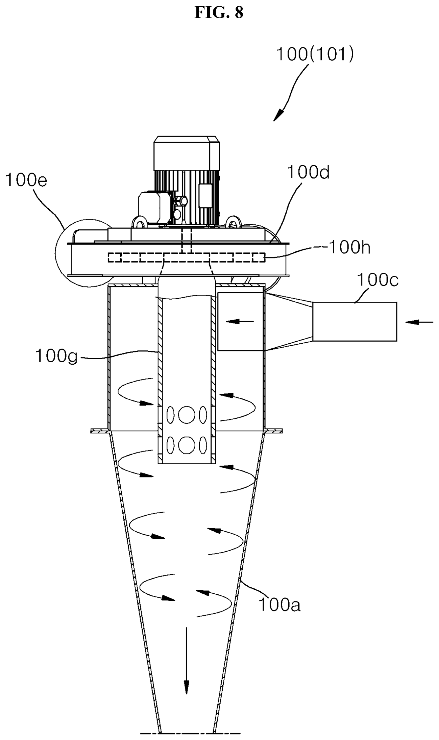

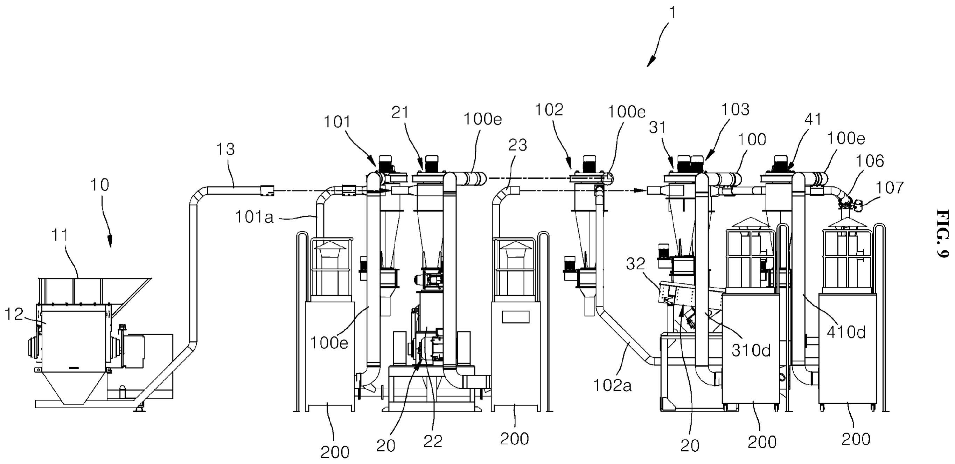

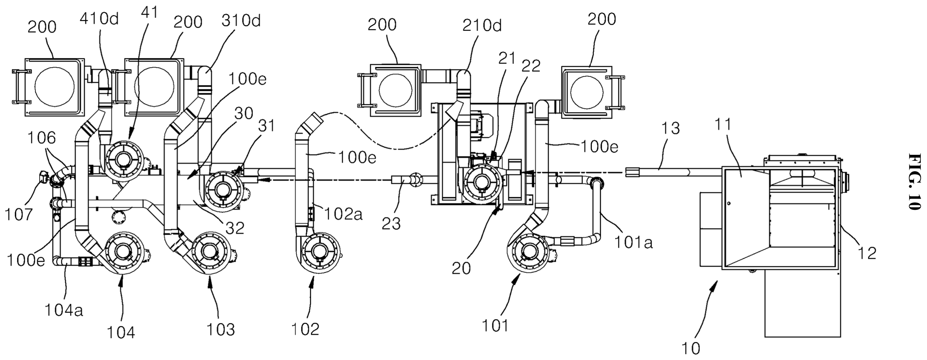

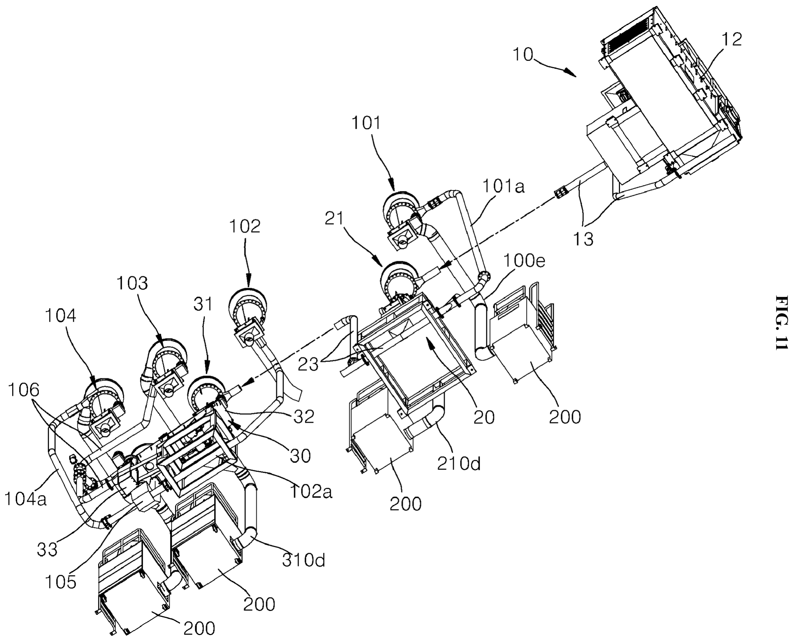

FIG. 7 is a front view of the crushing and separation/recovery apparatus of FIG. 3, FIG. 8 is a sectional view illustrating an internal structure of a recovery unit included in the crushing and separation/recovery apparatus of FIG. 7, FIG. 9 is a rear view of the crushing and separation/recovery apparatus of FIG. 3, FIG. 10 is a plan view of the crushing and separation/recovery apparatus of FIG. 3, and FIG. 11 is a perspective view of the crushing and separation/recovery apparatus of FIG. 3 as viewed from a bottom side.

The recovery units are also illustrated from different directions, and the following description refers to exploded views in which main portions are separated. Referring to FIGS. 7 and 10, the first recovery unit 101 is connected to the second crushing unit 20 through a first recovery conduit 101a, the second recovery unit 102 is connected to the particle-size classifying unit 32 through a second recovery conduit 102a, and the fourth recovery unit 104 is connected to the particle collection unit 105 (see FIG. 6) through a fourth recovery conduit 104a. The second recovery conduit 102a may be connected to the particle-size classifying unit 32 via the particle collection unit 105, and may be connected to a first outlet 321 (see FIG. 6) of the particle-size classifying unit so as to suction the first particles discharged through the first outlet.

The fourth recovery conduit 104a is also connected to the particle collection unit 105, but has a different function from the second recovery conduit. That is, the fourth recovery conduit 104a serves to discharge mixed particles formed by mixing the second particles supplied to the particle collection unit 105 through the branching flow path 106 (see FIG. 5) with the first particles supplied from the first outlet to the particle collection unit 105. Accordingly, the fourth recovery conduit 104a and the second recovery conduit 102a may branch in different directions from the particle collection unit 105 toward the fourth recovery unit 104 and the second recovery unit 102, respectively (see FIG. 6). The third recovery unit 103 may be connected to the gravity separation unit 33 through the branching flow path 106, which is connected at both sides to the particle collection unit 105 and the third recovery unit 103 so that the second particles separated in the gravity separation unit 33 can be selectively supplied to the third recovery unit 103 via the branching flow path 106.

That is, as illustrated in FIG. 10, the first recovery unit 101, the second recovery unit 102, the third recovery unit 103, and the fourth recovery unit 104 are each connected to the apparatus through different flow paths so as to selectively recover crushed material of the waste solar panel that is sequentially generated at different points of the apparatus. Specifically, the first recovery unit 101 is configured to suction the ground particles from the second crushing unit 20 by air pressure and discharge the ground particles through a nozzle, the second recovery unit 102 is configured to suction the first particles from the particle-size classifying unit 32 by air pressure and discharge the first particles through a nozzle, and the third recovery unit 103 is configured to suction the second particles from the gravity separation unit 33 by air pressure and discharge the second particles through a nozzle. The fourth recovery unit 104 is selectively used when separation between the first particles and the second particles is not necessary and, in that case, is configured to suction mixed particles of the first particles and the second particles from the particle collection unit 105 and discharge the mixed particles through a nozzle. Since the recovery units are formed to have substantially the same structure, the structure of the recovery units will be described with reference to FIG. 8, and their arrangement will then be described on the basis thereof.

In FIG. 8, a sectional view of a recovery unit 100 is illustrated. The recovery unit 100 of FIG. 8 corresponds to the first recovery unit 101 of FIG. 7, but since the first to fourth recovery units have substantially the same internal structure, each recovery unit will be collectively referred to as the recovery unit 100 in the following description. When referred to as the recovery unit 100, this is intended to encompass the first, second, third, and fourth recovery units.

Referring to FIG. 8, the recovery unit 100 (that is, the first to fourth recovery units) may integrally have functions of a suction device and a cyclone device. The recovery unit 100 may include a cyclone barrel 100a having a diameter decreasing downward, a nozzle 100b (see FIG. 7) formed at a lower end of the cyclone barrel 100a, a suction conduit 100c connected in a tangential direction to a side portion of the cyclone barrel 100a, and a suction fan 100d coupled to an upper end of the cyclone barrel 100a and configured to generate a negative pressure. If necessary, a shutoff member 100f (see FIG. 7) for intermittently opening and closing a flow path may also be provided between the cyclone barrel 100a and the nozzle 100b in each recovery unit.

The suction fan 100d may be installed at the upper end of the cyclone barrel 100a so as to be in communication with an interior of the cyclone barrel 100a. For example, the suction fan 100d may be configured such that fluid can be suctioned from the cyclone barrel 100a through a central passage 100g located at the center of the cyclone barrel 100a. The suction fan 100d may be a centrifugal fan in which blades 100h rotating in a horizontal direction are driven by a motor. For example, the suction fan 100d may have a structure in which fluid is introduced in an axial direction through the central passage 100g and then discharged in a centrifugal direction by the blades 100h.

When the suction fan 100d is driven, negative pressure is generated inside the cyclone barrel 100a, and, as illustrated, crushed material (at least one of the ground particles, the first particles, and the second particles) is suctioned in a tangential direction into the cyclone barrel 100a through the suction conduit 100c. Accordingly, the particles rotate and fall downward in the cyclone barrel 100a (that is, in a direction toward the nozzle). At this time, due to centrifugal force, dust having a lower density is separated from the crushed material and gathers in the center, so the dust can be discharged upward through the central passage 100g. That is, the recovery unit 100 can remove dust by centrifugal separation due to a cyclone effect (centrifugal separation effect caused by rotation of material) inside the cyclone barrel 100a and discharge only recovered material (at least one of the ground particles, the first particles, and the second particles) through the nozzle 100b at the lower side (see FIG. 7).

For effective removal of dust, the recovery unit 100 (that is, the first to fourth recovery units) may further be connected to a dust discharge duct 100e configured to suction and discharge dust to a dust collector 200 (see FIG. 10). The dust discharge duct 100e may be connected to the suction fan 100d that suctions centrifugally separated dust upward. Another end of the dust discharge duct 100e is connected to the dust collector 200 (see FIG. 10). The dust discharge duct 100e may be disposed in a tangential direction with respect to the cyclone barrel 100a so as to be favorable for accelerating dust-containing fluid by the blades 100h of the suction fan 100d (see FIG. 10).

That is, the recovery unit 100 may have both the suction conduit 100c for suctioning crushed material (at least one of the ground particles, the first particles, and the second particles) and the dust discharge duct 100e for discharging dust, and the suction conduit 100c and the dust discharge duct 100e may be doubly connected in tangential directions to a side portion and an upper end of the cyclone barrel 100a. Accordingly, suction of crushed material and discharge of dust can be achieved very effectively at the same time. Furthermore, since suction force from the dust collector 200 can additionally be transmitted through the dust discharge duct 100e, a suction force of the recovery unit 100 can be further increased by controlling loads of the suction fan 100d and the dust collector 200 together. This structure may also be advantageous for suctioning relatively heavy crushed material generated from the waste solar panel.

The first to fourth recovery units are all configured substantially identical to the recovery unit 100 of FIG. 8. However, since they selectively recover crushed material at different points, their arrangement states are all different. Therefore, the arrangement structures of the respective recovery units will be described in more detail below.

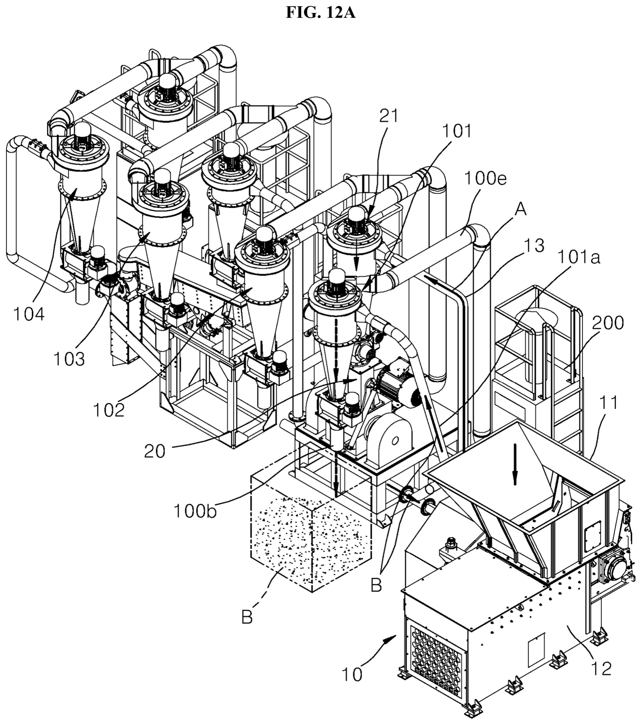

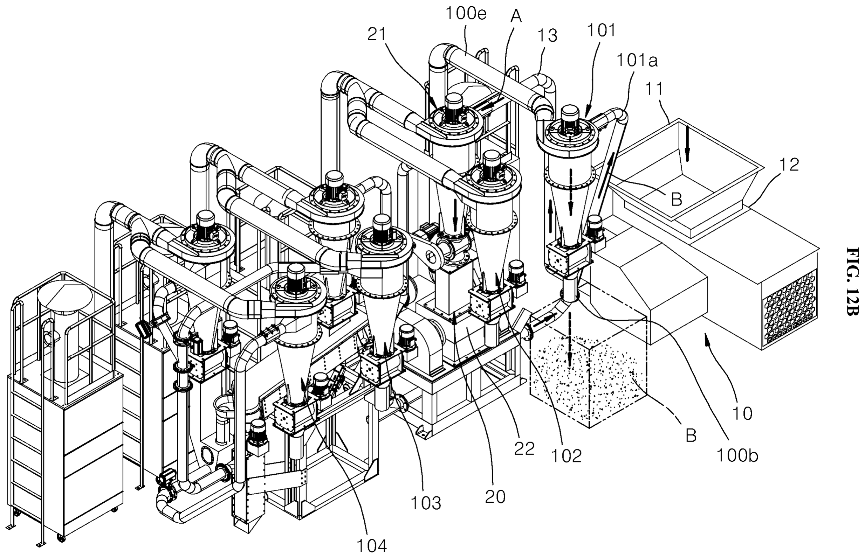

Referring to FIGS. 7 to 11, the first recovery unit 101 is connected to the second crushing unit 20 through the first recovery conduit 101a. The first recovery conduit 101a connects a lower end of the second crushing unit 20 and a side portion of the first recovery unit 101 so that the ground particles ground in the second crushing unit 20 can be supplied to the first recovery unit 101. The first recovery conduit 101a is connected to the suction conduit 100c (see FIG. 8) formed in the first recovery unit 101 in a tangential direction (that is, in a tangential direction of the cyclone barrel), thereby inducing rotation (see arrows in FIG. 8) by injecting the ground particles tangentially. The dust discharge duct 100e, which discharges dust centrifugally separated by rotation of the ground particles, is connected to the dust collector 200 along a path independent of the first recovery conduit 101a at the upper end of the first recovery unit 101. With this structure, the first recovery unit 101 can suction the ground particles B (see FIG. 12) from the second crushing unit 20, remove dust therefrom, and then discharge the ground particles through the nozzle 100b (see FIG. 12).

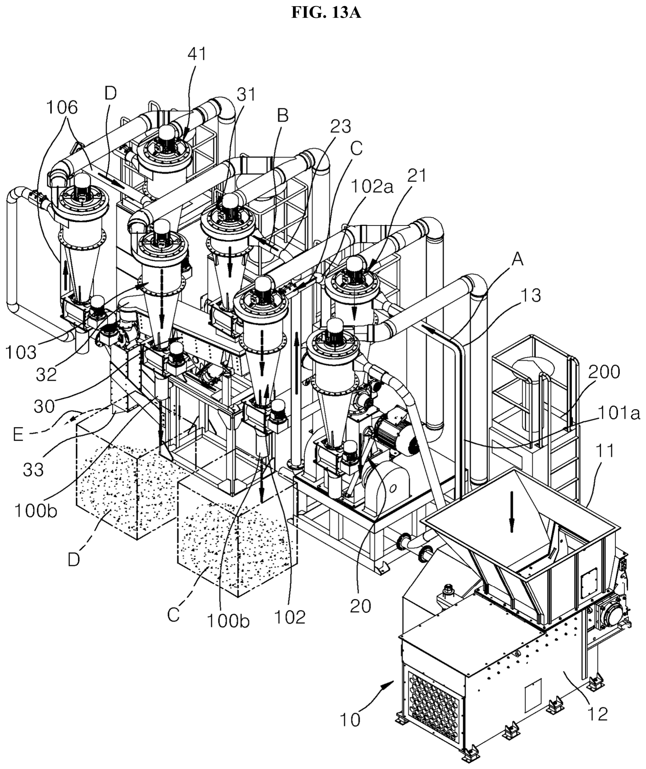

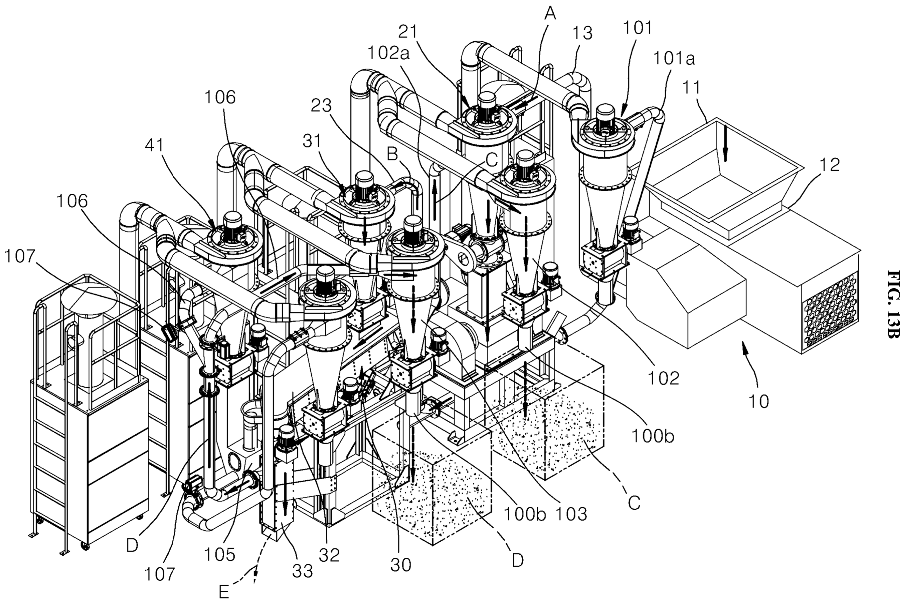

Referring to FIGS. 7 to 11, the second recovery unit 102 is connected to the particle-size classifying unit 32 through the second recovery conduit 102a. The second recovery conduit 102a connects the first outlet 321 (see FIG. 6) of the particle-size classifying unit 32 and a side portion of the second recovery unit 102 so as to supply the first particles discharged through the first outlet 321 to the second recovery unit 102. The second recovery conduit 102a may be connected to the particle-size classifying unit 32 via the particle collection unit 105, which is connected to the first outlet 321, and may be connected to the suction conduit 100c (see FIG. 8) formed in the second recovery unit 102 in a tangential direction so as to induce rotation (see arrows in FIG. 8) of the first particles. The dust discharge duct 100e, which discharges dust centrifugally separated by rotation of the first particles, is connected to the dust collector 200 along a path independent of the second recovery conduit 102a at the upper end of the second recovery unit 102. With this structure, the second recovery unit 102 can suction the first particles C (see FIG. 13) from the particle-size classifying unit 32, remove dust therefrom, and then discharge the first particles through the nozzle 100b (see FIG. 13).

Referring to FIGS. 7 to 11, the third recovery unit 103 is connected to the gravity separation unit 33 (see FIG. 6) through the branching flow path 106 (see FIG. 10). Since the branching flow path 106 is branched at least once from the gravity separation unit 33 and connected to both the third recovery unit 103 and the particle collection unit 105, the second particles separated in the gravity separation unit 33 can be selectively supplied to the third recovery unit 103 via the branching flow path 106. The branching flow path 106 may connect an upper end of the gravity separation unit 33 and a side portion of the third recovery unit 103, and may be connected to the suction conduit 100c (see FIG. 8) formed in the third recovery unit 103 in a tangential direction so as to induce rotation (see arrows in FIG. 8) of the second particles. The dust discharge duct 100e, which discharges dust centrifugally separated by rotation of the second particles, is connected to the dust collector 200 along a path independent of the branching flow path 106 at the upper end of the third recovery unit 103. With this structure, the third recovery unit 103 can suction the second particles D (see FIG. 13) from the gravity separation unit 33, remove dust therefrom, and then discharge the second particles through the nozzle 100b (see FIG. 13).

The structures of the particle collection unit 105, which allows selective separation of particles, and the branching flow path 106 will be described in more detail as follows.

Referring to FIGS. 5 and 6, the particle collection unit 105 is connected to the first outlet 321 of the particle-size classifying unit 32 and is also connected to the gravity separation unit 33 through the branching flow path 106. Therefore, the particle collection unit 105 may receive only the first particles (discharged through the first outlet), or, as needed, may receive the second particles additionally through the branching flow path 106 and mix the second particles with the first particles. The particle collection unit 105 is further connected to the first recovery conduit 101a and the fourth recovery conduit 104a, and therefore can selectively supply either the first particles or mixed particles (formed by mixing the first particles and the second particles) to the first recovery unit 101 or the fourth recovery unit 104. For example, the particle collection unit 105 may have a structure such as a chamber or hopper in which two inflow sides and two discharge sides are appropriately formed.

Referring to FIGS. 5 and 6, one side of the particle collection unit 105 is connected to the first outlet 321 of the particle-size classifying unit 32. The first outlet 321 and the particle collection unit 105 may be connected by using an appropriate conduit. A portion of the particle collection unit 105 connected to the particle-size classifying unit 32 corresponds to a first inflow side that receives the first particles from the particle-size classifying unit 32.

The particle collection unit 105 extends upward at an upper portion thereof, and the third suction unit 41 is formed at such an upper portion. The branching flow path 106 is connected from the gravity separation unit 33 to the particle collection unit 105 via the third suction unit 41. Therefore, the particle collection unit 105 can receive the second particles through the branching flow path 106, as needed. A portion of the particle collection unit 105 connected to the branching flow path 106 (the upper portion at which the third suction unit is formed) corresponds to a second inflow side that receives the second particles from the gravity separation unit 33.

Referring to FIG. 5, the branching flow path 106 extends from the upper end of the gravity separation unit 33 and is branched at least once, and is then connected to both the particle collection unit 105 and the third recovery unit 103. Accordingly, the flow path of the second particles separated in the gravity separation unit 33 can be selectively changed to the particle collection unit 105 or to the third recovery unit 103. In order to allow adjustment of such a flow path, two or more flow-path switching units 107 (for example, electronic valve devices) may be applied around a branching point of the branching flow path 106.

Referring to FIG. 6, the particle collection unit 105 has, at a lower end thereof, the second recovery conduit 102a (see FIG. 11) and the fourth recovery conduit 104a (see FIG. 11) connected in opposite directions. Therefore, either side can be selectively used to discharge the first particles or the mixed particles. That is, when the first particles are to be recovered by using the second recovery unit 102, the second recovery conduit 102a is used, and when the mixed particles of the first particles and the second particles are to be recovered by using the fourth recovery unit 104, the fourth recovery conduit 104a is selectively used. For this purpose, flow-path switching units 107 capable of opening and closing each flow path may also be installed in the second recovery conduit 102a and the fourth recovery conduit 104a. That is, portions of the particle collection unit 105 connected to the first recovery conduit 101a and to the fourth recovery conduit 104a correspond to two discharge sides that selectively discharge either the first particles or the mixed particles. By configuring the particle collection unit 105, which can collect and distribute particles, together with the branching flow path 106, which changes a flow path of particles, the second particles can be independently recovered by the third recovery unit 103, or the mixed particles of the second particles and the first particles can be recovered by the fourth recovery unit 104.

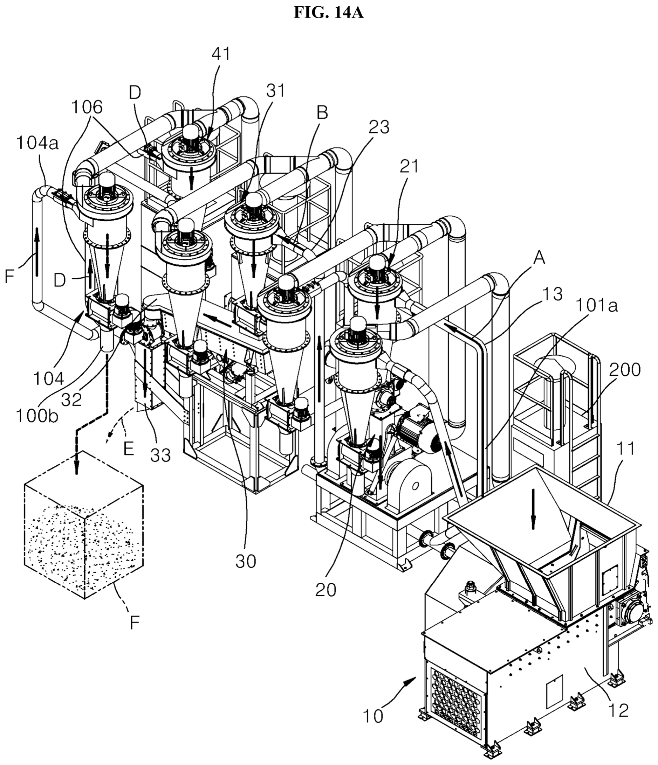

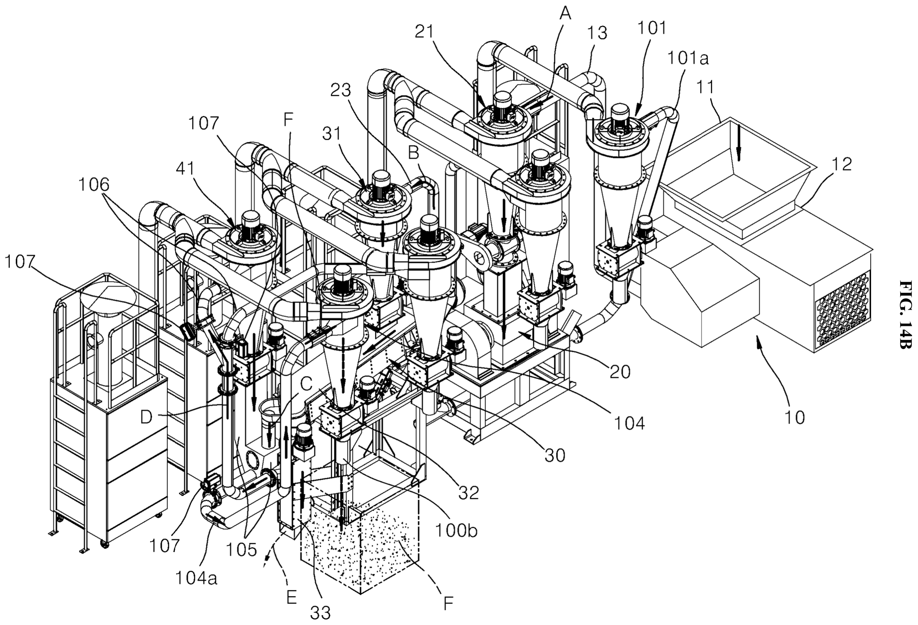

Referring to FIGS. 7 to 11, the fourth recovery unit 104 is connected to the particle collection unit 105 (see FIG. 11) through the fourth recovery conduit 104a. Accordingly, when the first particles and the second particles are mixed in the particle collection unit 105, mixed particles of the first particles and the second particles can be suctioned through the fourth recovery conduit 104a. The fourth recovery conduit 104a may connect a lower end of the particle collection unit 105 and a side portion of the fourth recovery unit 104, and may be connected to the suction conduit 100c (see FIG. 8) formed in the fourth recovery unit 104 in a tangential direction so as to induce rotation (see arrows in FIG. 8) of the mixed particles. A dust discharge duct 100e, which discharges dust centrifugally separated by rotation of the mixed particles, is connected from an upper end of the fourth recovery unit 104 to the dust collector 200 along a path independent of the fourth recovery conduit 104a. With this structure, the fourth recovery unit 104 can suction the mixed particles F (see FIG. 14) from the particle collection unit 105, remove dust therefrom, and then discharge the mixed particles through the nozzle 100b (see FIG. 14).

In this case, the first suction unit 21, the second suction unit 31, and the third suction unit 41, like the recovery units 100 (see FIG. 8), can sequentially remove dust at respective positions. That is, each suction unit may also be formed to have an integrated structure having functions of a suction device and a cyclone device. For example, the suction units (that is, the first suction unit, the second suction unit, and the third suction unit) may each include an auxiliary cyclone barrel 210a (see FIG. 7) having a diameter decreasing downward, an auxiliary suction conduit 210b (see FIG. 7) connected in a tangential direction to a side portion of the auxiliary cyclone barrel, and an auxiliary suction fan 210c (see FIG. 7) coupled to an upper end of the auxiliary cyclone barrel and configured to generate a negative pressure. Such a structure is illustrated for the second suction unit 31, but the first suction unit 21 and the third suction unit 41 have the same structure, and thus all of the suction units can perform equivalent operations. If necessary, a shutoff member 210e (see FIG. 7) for intermittently opening and closing a flow path may also be formed at a lower end of the auxiliary cyclone barrel of the suction unit.

Since the auxiliary cyclone barrel, the auxiliary suction conduit, and the auxiliary suction fan constituting each suction unit are substantially the same in structure as the cyclone barrel, suction conduit, and suction fan of the recovery unit described above, their operational effects can be understood accordingly. Therefore, each suction unit can also remove dust by centrifugal separation and discharge only the suctioned crushed material downward. For dust discharge, each suction unit may be provided with an auxiliary dust discharge duct 210d, 310d, and 410d (see FIG. 11) connected to the respective auxiliary suction fan, and the auxiliary dust discharge ducts 210d, 310d, and 410d and the dust discharge ducts 100e may be appropriately integrated and connected to the dust collector 200.

From this standpoint, the present invention can also be understood as having the following configuration. The crushing and separation/recovery apparatus 1 of the present invention includes the first crushing unit 10, the second crushing unit 20, and the particle separation unit 30 including the particle-size classifying unit 32 and the gravity separation unit 33, as described above; the recovery unit 100 (see FIG. 8) configured to suction, by air pressure, any one of the ground particles, the first particles, and the second particles from any one of the second crushing unit 20, the particle-size classifying unit 32, and the gravity separation unit 33 and discharge the suctioned particles through a nozzle; and the dust collector 200 connected to the recovery unit 100, and may thus be understood as having a feature that, when any one of the ground particles, the first particles, and the second particles is recovered through the recovery unit 100, dust is removed from recovered material (that is, at least one of the ground particles, the first particles, and the second particles). That is, as described above, in the recovery unit 100, dust centrifugally separated inside the cyclone barrel 100a (see FIG. 8) is discharged to the dust collector 200 through the dust discharge duct 100e (see FIG. 8), and any one of the ground particles, the first particles, and the second particles is discharged through the nozzle 100b (see FIG. 7), so that dust can be effectively removed at all stages of the process. Since the suction units (the first suction unit, the second suction unit, and the third suction unit) also have the same structure and can remove dust, the purity of final recovered material is greatly improved.

In addition, since the suction force of the recovery unit 100 can be adjusted by simultaneously adjusting a load of the suction fan 100d (see FIG. 8) and a load of the dust collector 200, a suction capacity can be increased or decreased as desired. That is, since the dust collector 200 itself includes a structure (for example, a fan or pump) configured to suction dust, the suction force can be adjusted more strongly (or weakly) by using the recovery unit 100 and the dust collector 200 together, and the components of the waste solar panel can be recovered more effectively.

Hereinafter, based on this structure, the operating method of the present invention will be described in more detail. The present invention can selectively recover components of waste solar panels through at least three processes, which will be described with reference to FIGS. 12A to 17.

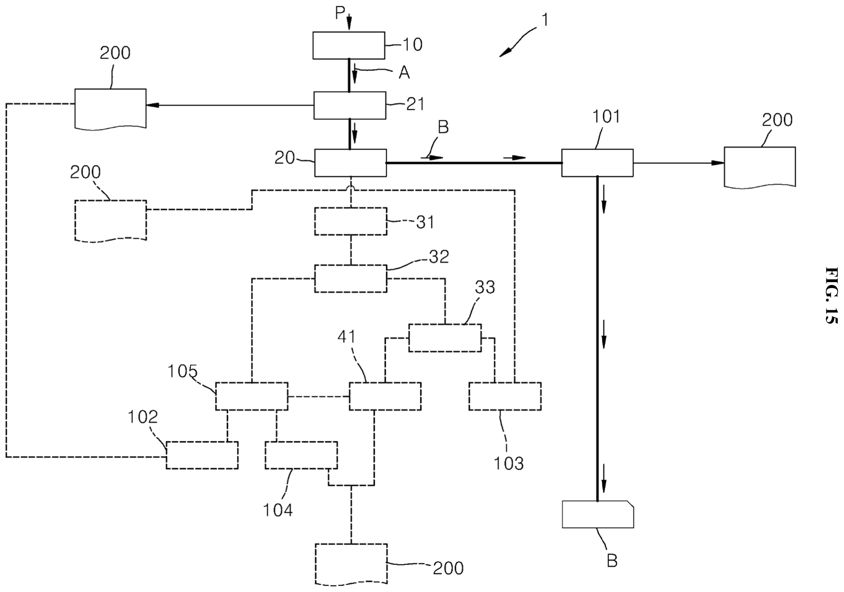

FIGS. 12A and 12B are operational views illustrating a first recovery process of the crushing and separation/recovery apparatus of FIG. 2 from different angles, FIGS. 13A and 13B are operational views illustrating a second recovery process of the crushing and separation/recovery apparatus of FIG. 2 from different angles, FIGS. 14A and 14B are operational views illustrating a third recovery process of the crushing and separation/recovery apparatus of FIG. 2 from different angles, and FIGS. 15 to 17 are process diagrams schematically illustrating first to third recovery processes shown in FIGS. 12A to 14B.

Since the processes of the present invention can be understood in accordance with the method of the present invention, the following description can also be applied as a description of the method described later. The description of the processes (or operating modes) will be made with reference to other drawings on the basis of the process diagrams of FIGS. 15 to 17.

First, referring to FIG. 15, by driving the first crushing unit 10, the second crushing unit 20, and the first recovery unit 101, it is possible to recover all of the ground particles B formed by crushing the waste solar panel P without classification. This process may be a first recovery process. In the first recovery process, the waste solar panel P is crushed in the first crushing unit 10 into the crushed material A having a size allowing the crushed material to be transported through a flow path, is re-ground in the second crushing unit 20, and is thus converted into the ground particles B having a particle size smaller than that of the crushed material A. The ground particles B ground in the second crushing unit 20 are recovered through the first recovery unit 101.

Referring to FIGS. 12A and 12B, a flow of the process can be more clearly understood. The waste solar panel (not shown) is introduced into the inlet 11 of the first crushing unit 10, is crushed into the crushed material A, and is then supplied to the second crushing unit 20 via the first transport conduit 13 and the first suction unit 21. The crushed material re-ground in the second crushing unit 20 is converted into the ground particles B having a smaller particle size, and the ground particles B are suctioned into the first recovery unit 101 through the first recovery conduit 101a and then discharged through the nozzle 100b.

Accordingly, as illustrated, by arranging a collection box or the like under the first recovery unit 101, the ground particles B, which are crushed material of the waste solar panel, can be easily recovered. In this process, components other than those required may be stopped to save power.

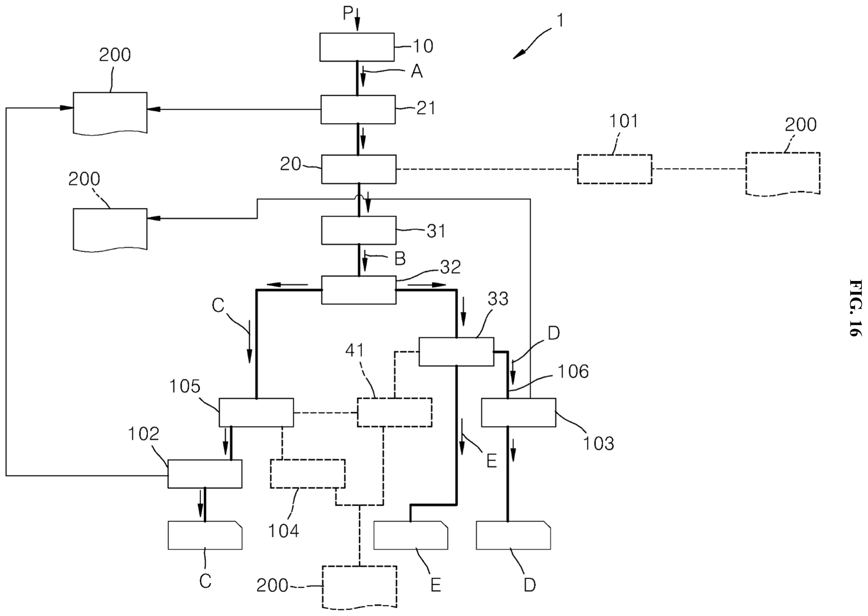

Meanwhile, referring to FIG. 16, by driving the first crushing unit 10, the second crushing unit 20, the particle separation unit [the particle-size classifying unit 32 and the gravity separation unit 33], the second recovery unit 102, and the third recovery unit 103, the first particles C, the second particles D, and the third particles E can be selectively recovered along independent paths. This process may be a second recovery process. In this case, the first particles C may be silicon (including metallurgical-grade silicon), and the third particles E may be copper. The second particles D may be a mixture of the remaining components.

In the second recovery process, after the waste solar panel P is sequentially converted into the crushed material A and the ground particles B in the first crushing unit 10 and the second crushing unit 20, the waste solar panel P passes through the particle-size classifying unit 32 and the gravity separation unit 33 and is separated into the first particles C, the second particles D, and the third particles E in three phases. The first particles C are recovered through the second recovery unit 102 (possibly via the particle collection unit), the second particles D are recovered through the third recovery unit 103, and the third particles E are directly discharged from the gravity separation unit 33.

Referring to FIGS. 13A and 13B, a flow of the above process can also be clearly understood. The process for generating the ground particles B by passing through the first crushing unit 10 and the second crushing unit 20 is the same as in the first recovery process. However, in the second recovery process, the ground particles B are supplied again to the particle-size classifying unit 32 via the second transport conduit 23 and the second suction unit 31. The first particles C, which are primarily separated in the particle-size classifying unit 32, are suctioned through the second recovery conduit 102a into the second recovery unit 102 and then discharged through the nozzle 100b.

Meanwhile, the intermediate particles remaining after the first particles C are separated in the particle-size classifying unit 32 are introduced into the gravity separation unit 33 and are re-separated into the second particles D and the third particles E according to a difference in specific gravity. The third particles E (copper) fall downward by their own weight to a lower portion of the gravity separation unit 33 and are collected, and the second particles D are suctioned through the branching flow path 106 into the third recovery unit 103 and then discharged through the nozzle 100b.

At this time, in the branching flow path 106, a side connected to the particle collection unit 105 is closed by the flow-path switching unit 107, and a flow path of the second particles D is formed toward the third recovery unit 103. Accordingly, the second particles D are suctioned into the third recovery unit 103 and are recovered along a path independent of the first particles C and the third particles E.

In the second recovery process, separate collection boxes can be arranged at the second recovery unit 102, the third recovery unit 103, and the gravity separation unit 33 so that the first particles C, the second particles D, and the third particles E can all be recovered along independent paths. Therefore, silicon components (the first particles) and copper components (the third particles) of the waste solar panel can be completely separated and efficiently recycled. In addition, other components (the second particles) can also be recovered along a different path and treated separately.

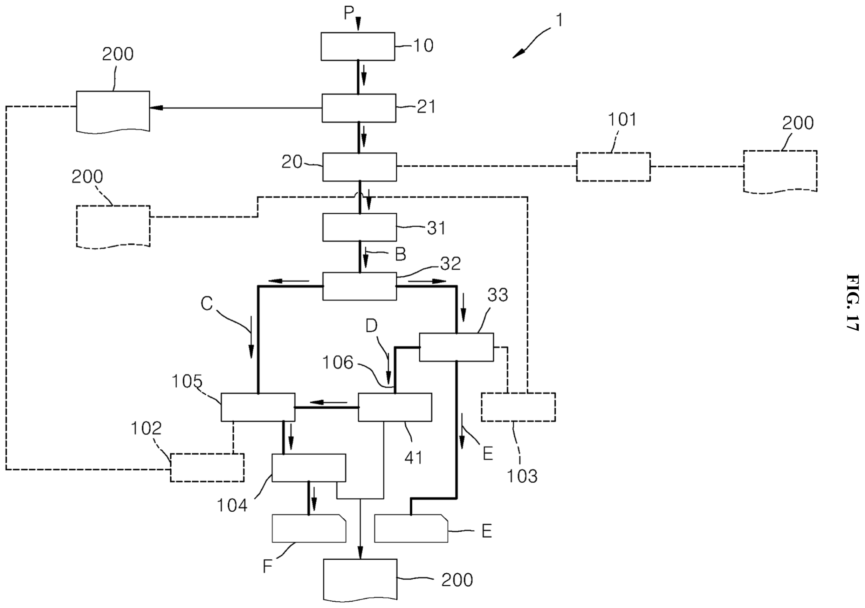

Meanwhile, referring to FIG. 17, by driving the first crushing unit 10, the second crushing unit 20, the particle separation unit [the particle-size classifying unit 32 and the gravity separation unit 33], and the fourth recovery unit 104, it is also possible to selectively recover the third particles E (copper) and the mixed particles F of the first particles and the second particles as two types of recovered material. That is, when it is not necessary to separately recover the second particles, the second particles may be mixed with the first particles by adjusting the flow paths, and may then be recovered as mixed particles F separately from the copper (the third particles). This process may be a third recovery process.

Referring to FIGS. 14A and 14B, the third recovery process includes a step of mixing the second particles D, which were separated in the second recovery process, with the first particles C by changing a flow path. That is, the process in which the waste solar panel passes through the first crushing unit 10, the second crushing unit 20, and the particle separation unit [the particle-size classifying unit 32 and the gravity separation unit 33] and is separated into the first particles C, the second particles D, and the third particles E is the same as in the second recovery process. However, in the third recovery process, a flow path of the second particles D is changed by the branching flow path 106 so that the second particles D are supplied from the gravity separation unit 33 to the particle collection unit 105 and then mixed with the first particles C. The mixed particles F, in which the first particles and the second particles are mixed, are suctioned into the fourth recovery unit 104 through the fourth recovery conduit 104a and then discharged through the nozzle 100b.

At this time, since the particle collection unit 105 can receive the first particles C from the first outlet 321 of the gravity separation unit 33, when the second particles D are supplied through the branching flow path 106, the first particles C and the second particles D can be mixed inside the particle collection unit 105. Since the mixed particles are changed in composition into the mixed particles F, they are suctioned along a flow path (the fourth recovery conduit) different from the previous flow path and are recovered by the fourth recovery unit 104.

In this case, contrary to the second recovery process, in the branching flow path 106, a side connected to the third recovery unit 103 is closed by the flow-path switching unit 107, and a flow path of the second particles D is changed to a side toward the particle collection unit 105. Accordingly, the second particles D are supplied to the particle collection unit 105 and are automatically mixed with the first particles C. Through this process, the third particles E (copper) are recovered at a lower end of the gravity separation unit 33, and the mixed particles F of the first particles and the second particles are selectively recovered by the fourth recovery unit 104.

Accordingly, in the present invention, different components can be recovered from each of the first to fourth recovery units, and the types of components to be selectively recovered can be adjusted as needed. Thus, useful components can be automatically classified and recovered simultaneously with disposal of the waste solar panel, and can be immediately recycled. In this manner, crushing and separation/recovery of waste solar panels can be achieved according to the present invention.

Hereinafter, a method for crushing and separating/recovering waste solar panels (hereinafter, simply referred to as a "crushing and separation/recovery method") according to the present invention will be described in detail. The method of the present invention can be understood in accordance with the operation process of the apparatus described above, and thus will be described on the basis of the process diagrams of FIGS. 16 and 17 illustrating the recovery processes. Matters not specifically mentioned in the description of the method are in accordance with the description given above.

The crushing and separation/recovery method according to the present invention can be performed by using the crushing and separation/recovery apparatus described above, and is particularly characterized in the selection processes of the first particles, the second particles, and the third particles. The crushing and separation/recovery method includes:
step (a) of crushing a waste solar panel P into the crushed material A having a size allowing the crushed material to be transported through a flow path;
step (b) of re-grinding the crushed material A so as to convert the crushed material into the ground particles B having a particle size smaller than that of the crushed material;
step (c) of, in the particle-size classifying unit 32, separating the ground particles B into the first particles C having a particle size smaller than a reference particle size and intermediate particles having a particle size larger than the reference particle size;
step (d) of, in the gravity separation unit 33, re-separating the intermediate particles into the second particles D having a smaller specific gravity and the third particles E having a larger specific gravity according to a difference in specific gravity; and
step (e) of separating and recovering the first particles C and the third particles E respectively from the particle-size classifying unit 32 and the gravity separation unit 33. This process corresponds to the above-described second and third recovery processes.

Each of the above steps can be performed by using the first crushing unit, the second crushing unit, the particle separation unit (the particle-size classifying unit and the gravity separation unit), the first to fourth recovery units, the particle collection unit, and the branching flow path, as described above. Therefore, for related matters, reference may be made to the description given above.

In step (e), the second particles D may be selectively recovered along a first path independent of recovery paths of the first particles C and the third particles E, or along a second path identical to a recovery path of the first particles C. These correspond to the above-described second recovery process (in which the second particles are recovered along an independent path) and the third recovery process (in which the second particles are recovered along the same path as the first particles), respectively.

In this case, the first path may be a path along which the second particles are recovered by the third recovery unit described above, and the second path may be a path along which the second particles are recovered by the fourth recovery unit described above after being mixed with the first particles. Accordingly, as described above, the second particles D can be selectively recovered separately from other particles or recovered in a state mixed with the first particles C by adjusting the flow paths, as needed. Through this, the types of components to be selectively recovered can be adjusted as required.

In particular, when the second particles D are recovered along the same path as the first particles C, the second particles D may pass through the particle collection unit 105 described above. That is, the second particles D may be recovered in the state of the mixed particles F mixed with the first particles after passing through the particle collection unit 105, which is configured to suction the second particles D from the gravity separation unit 33 and mix the second particles with the first particles C. This process corresponds to the above-described third recovery process, and thus specific details may be referred to in the above description.

Accordingly, in the present invention, while components different in composition, that is, the first particles C (silicon) and the third particles E (copper), are separately recovered, the remaining components (the second particles) may be independently recovered or recovered in a state mixed with the first particles C, as needed. That is, by adjusting the types of components to be selectively recovered, the convenience of recycling can be further increased. In this manner, waste solar panels can be crushed and separated/recovered in various ways.

Although embodiments of the present invention have been described above with reference to the accompanying drawings, it will be understood by those skilled in the art that the present invention may be practiced in other specific forms without changing the technical spirit or essential features of the invention. Accordingly, the embodiments described above are to be understood in all respects as illustrative and not limiting.

## Claims

1. A waste solar panel crushing and separation/recovery apparatus comprising:
a first crushing unit configured to crush a waste solar panel into crushed material having a size allowing the crushed material to be transported through a flow path;
a second crushing unit configured to re-grind the crushed material so as to convert the crushed material into ground particles having a particle size smaller than that of the crushed material;
a particle separation unit comprising a particle-size classifying unit configured to separate the ground particles into first particles having a particle size smaller than a reference particle size and intermediate particles having a particle size larger than the reference particle size, and a gravity separation unit connected to the particle-size classifying unit and configured to re-separate the intermediate particles into second particles lighter in specific gravity and third particles heavier in specific gravity;
a first recovery unit configured to suction the ground particles from the second crushing unit by air pressure and discharge the ground particles through a nozzle;
a second recovery unit configured to suction the first particles from the particle-size classifying unit by air pressure and discharge the first particles through a nozzle; and
a third recovery unit configured to suction the second particles from the gravity separation unit by air pressure and discharge the second particles through a nozzle.

2. The waste solar panel crushing and separation/recovery apparatus of claim 1, further comprising:
a particle collection unit configured to suction the second particles from the gravity separation unit along a path different from the third recovery unit and mix the second particles with the first particles; and
a fourth recovery unit configured to suction mixed particles of the first particles and the second particles from the particle collection unit and discharge the mixed particles through a nozzle.

3. The waste solar panel crushing and separation/recovery apparatus of claim 2, further comprising a branching flow path disposed between the gravity separation unit and the particle collection unit and between the gravity separation unit and the third recovery unit, and configured to selectively change a flow path of the second particles to the particle collection unit or to the third recovery unit.

4. The waste solar panel crushing and separation/recovery apparatus of claim 2, wherein each of the first recovery unit, the second recovery unit, the third recovery unit, and the fourth recovery unit comprises a cyclone barrel having a diameter decreasing downward, a nozzle formed at a lower end of the cyclone barrel, a suction conduit connected in a tangential direction to a side portion of the cyclone barrel, and a suction fan coupled to an upper end of the cyclone barrel and configured to generate a negative pressure.

5. The waste solar panel crushing and separation/recovery apparatus of claim 4, wherein each of the first recovery unit, the second recovery unit, the third recovery unit, and the fourth recovery unit further comprises a dust discharge duct connected to the suction fan so that dust centrifugally separated is discharged to a dust collector through the dust discharge duct.

6. The waste solar panel crushing and separation/recovery apparatus of claim 5, wherein the suction conduit and the dust discharge duct are doubly connected in tangential directions to a side portion and an upper end of the cyclone barrel.

7. The waste solar panel crushing and separation/recovery apparatus of claim 1, further comprising:
a first suction unit disposed at an upper end of the second crushing unit and connected by a flow path to the first crushing unit so as to suction the crushed material into the second crushing unit; and
a second suction unit disposed at an upper end of the particle-size classifying unit and connected by a flow path to the second crushing unit so as to suction the ground particles into the particle-size classifying unit,
wherein each of the first suction unit and the second suction unit comprises an auxiliary cyclone barrel having a diameter decreasing downward, an auxiliary suction conduit connected in a tangential direction to a side portion of the auxiliary cyclone barrel, and an auxiliary suction fan coupled to an upper end of the auxiliary cyclone barrel and configured to generate a negative pressure.

8. The waste solar panel crushing and separation/recovery apparatus of claim 1, wherein the particle-size classifying unit comprises a vibrating particle classifier including a sieve, and the gravity separation unit comprises an airflow gravity separator.

9. The waste solar panel crushing and separation/recovery apparatus of claim 8, wherein the first particles are silicon and the third particles are copper.

10. A method for crushing and separating/recovering waste solar panels, comprising:
(a) crushing a waste solar panel into crushed material having a size allowing the crushed material to be transported through a flow path;
(b) re-grinding the crushed material so as to convert the crushed material into ground particles having a particle size smaller than that of the crushed material;
(c) in a particle-size classifying unit, separating the ground particles into first particles having a particle size smaller than a reference particle size and intermediate particles having a particle size larger than the reference particle size;
(d) in a gravity separation unit, re-separating the intermediate particles into second particles having a smaller specific gravity and third particles having a larger specific gravity according to a difference in specific gravity; and
(e) separating and recovering the first particles and the third particles respectively from the particle-size classifying unit and the gravity separation unit.

11. The method for crushing and separating/recovering waste solar panels of claim 10, wherein, in step (e), the second particles are recovered along a first recovery path independent of recovery paths of the first particles and the third particles, or are recovered along a second recovery path identical to a recovery path of the first particles.

12. The method for crushing and separating/recovering waste solar panels of claim 11, wherein, when the second particles are recovered along the second recovery path, the second particles are recovered in a state of mixed particles mixed with the first particles through a particle collection unit configured to suction the second particles from the gravity separation unit and mix the second particles with the first particles.

13. The method for crushing and separating/recovering waste solar panels of claim 10, wherein the particle-size classifying unit comprises a vibrating particle classifier including a sieve, and the gravity separation unit comprises an airflow gravity separator.

14. The method for crushing and separating/recovering waste solar panels of claim 13, wherein the first particles are silicon and the third particles are copper.
